# EUROPEAN PATENT APPLICATION

(11) **EP 1 434 277 A1**
(43) Date of publication of application: **30.06.2004**
(21) Application number: 02767941.4
(22) Date of filing: 10.09.2002
(51) Int. Cl.: H01L 33/00, F21V 5/04

(54) **CONDENSING ELEMENT AND FORMING METHOD THEREFOR AND CONDENSING ELEMENT−CARRYING LED LAMP AND LINEAR LIGHT EMITTING DEVICE USING LED LAMP AS LIGHT SOURCE**

(30) Priority: 11.09.2001 JP 2001274988; 11.09.2001 JP 2001275002; 02.11.2001 JP 2001337549
(71) Applicant: Bridgestone Corporation, Tokyo 104-8340 (JP)
(72) Inventor: TAZAWA, Hare BRIDGESTONE CORPORATION TechnicalCen, Kodaira-shi, Tokyo187-85 31 (JP); YOSHIKAWA,M. BRIDGESTONE CORPORATION Technical Cen, Kodaira-shi, Tokyo 187-8531 (JP)
(74) Representative: Whalley, Kevin
(86) International application number: PCT/JP2002/009236
(87) International publication number: WO 2003/026031

(57) **Abstract**

This invention proposes a beam-condensing element comprising a beam-condensing portion having a translucent concave end face, which is the same curvature as a translucent convex face of a LED lamp comprising a LED chip and a substantially hemispherical translucent convex face enveloping the LED chip, and extending from a peripheral edge of the translucent concave end face in a shape of a parabolic rotating body, in which when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value.

## Description

### TECHNICAL FIELD

This invention relates to a beam-condensing element and a method of forming the same, a LED lamp provided with the beam-condensing element, and a linear light-emitting apparatus using the LED lamp as a light source.

Moreover, this linear light-emitting apparatus is particularly suitable for use in lamp fittings for vehicles such as an interior light, a tail lamp, for example, a high mount brake lamp mounted on the vehicle and the like.

### BACKGROUND ART

The LED (Light Emitting Diode) lamp has such merits that a responsivity of light emission is fast, a power consumption is low, a service life is long, a size is small and the like. However, the LED lamp is low in the brightness as compared with lighting lamps such as a fluorescent lamp, an incandescent lamp and the like. To this end, it can not be used as lamp fittings for vehicles such as a brake lamp and the like, and is merely used in the partly limited applications such as, mainly, a pilot lamp, a digit present element and the like.

In recent years, however, there is a movement that the LED lamp having the above-mentioned merits is applied to various fields. For example, JP-Y-6-28725 discloses a lens for LED lamp capable of using as a lamp fitting for vehicles.

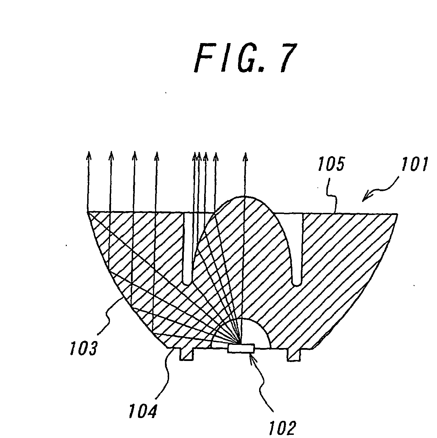

Such a lens 101 for LED lamp has a shape of a parabolic rotating body as sown in FIG. 7, in which light rays radially emitted from a LED lamp 102 can be efficiently emitted forward as substantially a parallel ray by capturing the greater part of these light rays in the above lens and reflecting most of the captured light rays on a side face 103 of the lens body or the like.

However, since the lens 101 captures the light rays emitted from the LED lamp 102, an area of an end face 104 located at a light-incidence side of the lens 101 is wide and hence an area of an end face 105 located at a light-emitting side of the lens becomes wider in proportion thereto. To this end, it has been confirmed that the size of the lens itself becomes larger and the spot diameter of the emitting light becomes also large, and hence a sufficient directivity can not be obtained and the light having a high brightness can not be emitted.

And also, there have hitherto been known an electric light such as a neon tube or a fluorescent lamp as an illuminant providing a linear light emission. As such an electric light needs a high voltage and involves the risk of electric shock or electric leak, it can not be used in a place of moisture such as rain or snow. In addition, since the electric light is made from a glass tube, there is a possibility that the glass tube is broken in a place being in danger of physically conflicting with people, vehicles or the like, and hence the electric light can not be used in such a place. Furthermore, when the electric light is used in the form of bending into a curved surface, it is required to conduct the glasswork so as to match with the curvature of the curved surface, which requires skill and brings about the increase of the cost. Moreover, since the consumed power is as large as about several tens W per a length of 1 m, when the electric light is used over a long period of time, it can not be used unless it is located in a place capable of utilizing the commercial power source. Therefore, the use of the electric light as an illuminant has the above-mentioned various problems.

On the contrary, although the LED (Light Emitting Diode)) lamp has the above-mentioned merits, it is a spot illuminant and is not preferable to use as a linear illuminant. However, it is recently attempted to form a linear light-emitting apparatus by using the LED lamp having the above-mentioned merits.

As a means for forming the linear illuminant by using the LED lamp is useful a method in which an optical transmission tube comprising a tubular clad, a core made of a material having a refractive index higher than that of a material constituting the tubular clad, and a reflecting layer zonally extending along a longitudinal direction of the tubular clad between the tubular clad and the core is used, and the LED lamp is arranged at an end face of the optical transmission tube, whereby a light emitted from the LED lamp is incident into the core and the incident light is reflected and scattered on the reflecting layer to emit from a peripheral face of the tubular clad located at a side opposite to a side forming the reflecting layer.

However, in case of using such a method, the light emitted from the LED lamp can not be incident into the optical transmission tube while being sufficiently condensed. Therefore, the efficiency of incidence into (the core of) the optical transmission tube is low and the quantity of light emitted from the optical transmission tube becomes low accompanied therewith and also the directivity is low, so that there is a problem that the brightness can not sufficiently be obtained.

### DISCLOSURE OF THE INVENTION

It is an object of the invention to provide a beam-condensing element capable of effectively gathering an incident light from a LED lamp in a beam-condensing portion without increasing an area of an end face located at an incident side of the beam-condensing element to emit a light having an excellent directivity and a high brightness, and a method of forming the beam-condensing element as well as a LED lamp provided with the beam-condensing element, and a linear light-emitting apparatus using the LED lamp as a light source.

In order to achieve the above object, the first aspect of the invention lies in a beam-condensing element comprising a beam-condensing portion having a translucent concave end face, which is the same curvature as a translucent convex face of a LED lamp comprising a LED chip and a substantially hemispherical translucent convex face enveloping the LED chip, and extending from a peripheral edge of the translucent concave end face in a shape of a parabolic rotating body, in which when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value, concretely, not less than 60%, preferably not less than 70%, more preferably not less than 85%.

In the first aspect of the invention, it is preferable that the inclination of tangent with respect to the rotation axis is a range of 0.15-1.00, preferably 0.2-0.8, more preferably 0.3-0.6, and that a length of the beam-condensing element is not less than 10 mm as measured on the rotation axis, and that an area of an end face located at a light-emitting side of the beam-condensing element is not more than 1000 mm², preferably not more than 625 mm², more preferably not more than 225 mm² and/or that the beam-condensing element is provided with a substantially cylindrical portion integrally united with the beam-condensing portion at the light-emitting side thereof.

The second aspect of the invention lies in a method of forming a beam-condensing element comprising a beam-condensing portion having a translucent concave end face, which is the same curvature as a translucent convex face of a LED lamp comprising a LED chip and a substantially hemispherical translucent convex face enveloping the LED chip, and extending from a peripheral edge of the translucent concave end face in a shape of a parabolic rotating body, which comprises forming a plurality of beam-condensing elements provided with beam-condensing portions having different inclinations of tangent drawn to the beam-condensing portion at a peripheral edge position of the translucent concave end face with respect to a rotation axis when viewing at a cross section including the rotation axis of the beam-condensing portion, putting each of these beam-condensing elements on a LED lamp, emitting a light from the LED lamp to measure an incidence efficiency when the light is incident into each of the beam-condensing elements, selecting an inclination of tangent that the measured incidence efficiency indicates not less than a given value from the above different inclinations, and then forming a beam-condensing element provided with a beam-condensing portion so as to satisfy the selected inclination of tangent.

In the second aspect of the invention, it is preferable that the beam-condensing element provided with the beam-condensing portion is formed by selecting a minimum value of the inclination of tangent in correspondence with a maximum value of the incidence efficiency among values of the incidence efficiency measured on the plural beam-condensing elements provided with beam-condensing portions having different inclinations of tangent with respect to the rotation axis and setting the inclination of tangent to a range of -20% to +50% of the selected minimum value.

The third aspect of the invention lies in a LED lamp with a beam-condensing element, which comprises a LED lamp comprising a LED chip and a substantially hemispherical translucent convex face enveloping the LED chip, and a beam-condensing element comprising a beam-condensing portion having a translucent concave end face, which is the same curvature as the translucent convex face of the LED lamp for putting on the translucent convex face thereof, and extending from a peripheral edge of the translucent concave end face in a shape of a parabolic rotating body, in which the LED lamp and the beam-condensing element are integrally united together, and when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value.

The fourth aspect of the invention lies in a linear light-emitting apparatus using a LED lamp as a light source, which comprises a LED lamp comprising a LED chip and a substantially hemispherical translucent convex face enveloping the LED chip, and a beam-condensing element comprising a beam-condensing portion having a translucent concave end face, which is the same curvature as the translucent convex face of the LED lamp for putting on the translucent convex face thereof, and extending from a peripheral edge of the translucent concave end face in a shape of a parabolic rotating body, and an illuminant joined to an end face located at a light-emitting side of the beam-condensing element or integrally molded to the beam-condensing element and provided with a reflection face reflecting the light emitted from the end face of the beam-condensing element at a given angle, concretely 60-150°, preferably 70-130°, more preferably 85-110° to emit linear light beams, in which the LED lamp, the beam-condensing element and the illuminant are integrally united together.

The fifth aspect of the invention lies in a linear light-emitting apparatus using a LED lamp as a light source, which comprises a LED lamp comprising a LED chip and a substantially hemispherical translucent convex face enveloping the LED chip, and a beam-condensing element comprising a beam-condensing portion having a translucent concave end face, which is the same curvature as the translucent convex face of the LED lamp for putting on the translucent convex face thereof, and extending from a peripheral edge of the translucent concave end face in a shape of a parabolic rotating body, and an illuminant joined to an end face located at a light-emitting side of the beam-condensing element or integrally molded to the beam-condensing element and provided with a reflection face reflecting the light emitted from the end face of the beam-condensing element and a luminous face linearly emitting light beans reflected from the reflection face, in which the LED lamp, the beam-condensing element and the illuminant are integrally united together, and a brightness uniformalizing means arranged on the reflection face of the illuminant.

In the fourth and fifth aspects of the invention, it is preferable that when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value, concretely, not less than 60%, preferably not less than 70%, more preferably not less than 85%.

And also, in the fourth and fifth aspects of the invention, it is preferable that the inclination of tangent with respect to the rotation axis is a range of 0.15-1.00, preferably 0.2-0.8, more preferably 0.3-0.6, and that a length of the beam-condensing element is not less than 10 mm as measured on the rotation axis, and that an area of an end face located at a light-emitting side of the beam-condensing element is not more than 1000 mm², preferably not more than 625 mm², more preferably not more than 225 mm² and/or that the beam-condensing element is provided with a substantially cylindrical portion integrally united with the beam-condensing portion at the light-emitting side thereof.

Furthermore, in the fourth and fifth aspects of the invention, it is preferable that the illuminant is substantially wedge-shape and a side face thereof has a shape of substantially a right-angled triangle comprising the reflection face as a hypotenuse, the luminous face located opposite to the reflection face as a base and a joint face to the beam-condensing element as the remaining side, and that the reflection face is zigzag formed by a connection of convex portions each comprised of two line segments extending in the different directions with respect to each other and an extending direction of either of the two line segments is made a given angle, concretely 25-55°, preferably 31-52°, more preferably 38-47° with respect to a forward direction of the light beam incident into the illuminant.

In addition, in the fourth and fifth aspects of the invention, it is preferable that in order to effectively capture the light emitted from the beam-condensing element in the illuminant, the joint face of the illuminant has an area capable of joining to a whole area of the end face located at the light-emitting side of the beam-condensing element.

Moreover, if it is required to arrange the illuminant apart from the position of the LED lamp as a light source, it is preferable that the illuminant is integrally connected to the beam-condensing element through an optical transmission tube.

Furthermore, it is preferable that the brightness uniformalizing means is constituted so that a reflectance of light on the reflection face of the illuminant is made larger at a part of the reflection face at least located at an end portion of the light-incidence side of the illuminant than at the other part of the reflection face located at the other portion of the illuminant. Concretely, it is preferable that an average inclination angle of the reflection face with respect to an extension of the rotation axis is made larger at a part of the reflection face at least located at the end portion of the light-incidence side of the illuminant than at other part of the reflection face and/or an average arranging number of the convex portions constituting the reflection face is made larger at a part of the reflection face at least located at the end portion of the light-incidence side of the illuminant than at other part of the reflection face.

### BRIEF DESCRIPTION OF THE DRAWINGS

FIG. 1 is a side view of a LED lamp with a beam-condensing element according to the third aspect of the invention;
FIG. 2 is a schematic view illustrating how to find the inclination of tangent m with respect to the rotation axis n;
FIG. 3 is a graph showing an embodiment of a relationship between the quantity of the light emitted and the inclination of tangent m with respect to the rotation axis n;
FIGS. 4A-4D are graphs showing a relationship between the spot diameter of the light irradiated and the quantity of the light emitted when using the beam-condensing elements of 4 mm, 10 mm, 20 mm and 30 mm in length L, respectively;
FIG. 5 is a bar chart showing the quantity of the light emitted with respect to a distance from a center position in the spot diameter when using the invention lamp;
FIG. 6 is a bar chart showing the quantity of the light emitted with respect to a distance from a center position in the spot diameter when using the conventional lamp;
FIG. 7 is a longitudinal section view of the conventional LED lamp with a beam-condensing element;
FIG. 8 is a side view of a linear light-emitting apparatus according to the fourth aspect of the invention;
FIG. 9 is a side view of another linear light-emitting apparatus according to the invention;
FIG. 10 is a side view of another linear light-emitting apparatus according to the invention;
FIG. 11 is a side view of another linear light-emitting apparatus according to the invention;
FIG. 12 is a side view of a linear light-emitting apparatus according to the fifth aspect of the invention;
FIG. 13A is a photograph in place of a drawing showing a brightness distribution of a linear light emitted from an illuminant of another linear light-emitting apparatus according to the fifth aspect of the invention;
FIG. 13B is a side view of the illuminant of the linear light-emitting apparatus used in FIG. 13A;
FIG. 14A is a photograph in place of a drawing showing a brightness distribution of a linear light emitted from an illuminant of another linear light-emitting apparatus according to the fifth aspect of the invention;
FIG. 14B is a side view of the illuminant of the linear light-emitting apparatus used in FIG. 14A;
FIG. 15 is a side view of an illuminant of another linear light-emitting apparatus according to the fifth aspect of the invention;
FIG. 16A is a photograph in place of a drawing showing a brightness distribution of a linear light emitted from an illuminant of a linear light-emitting apparatus of a comparative example; and
FIG. 16B is a side view of the illuminant of the linear light-emitting apparatus used in FIG. 16A.

### BEST MODE FOR CARRYING OUT THE INVENTION

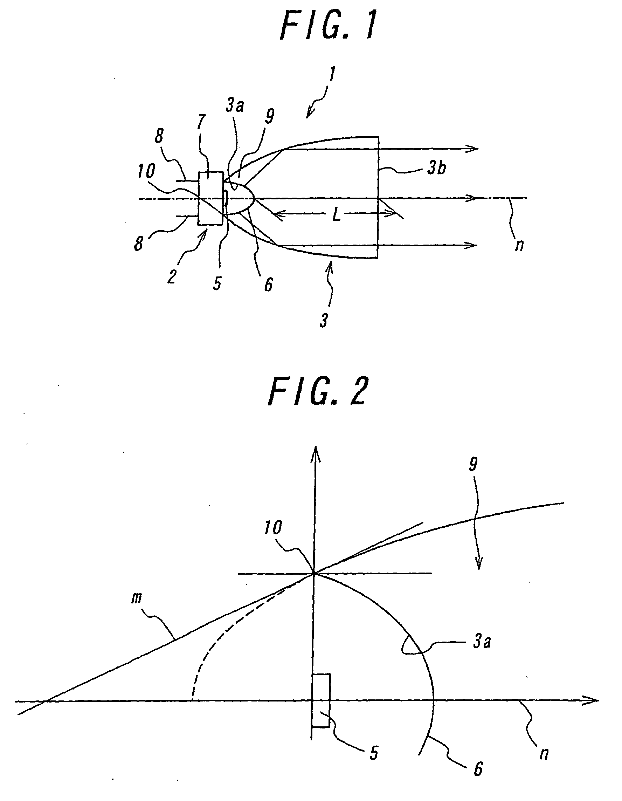

In FIG. 1 is shown an embodiment of a representative side view of a LED lamp with a beam-condensing element according to the third aspect of the invention constituted by placing a beam-condensing element according to the first aspect of the invention on a LED lamp and integrally uniting them.

The LED lamp 1 with the beam-condensing element shown in FIG. 1 is mainly comprised of a LED lamp 2 and a beam-condensing element 3.

The LED lamp 2 comprises a LED chip 5 and a substantially hemispherical translucent convex face 6 enveloping the LED chip 5.

In FIG. 1 is shown a case that the LED chip 5 is attached to an upper face of a base 7 and external leads 8 are extended from a lower face of the base 7. However, the attaching position of the LED chip 5 may be in the base 7 or above the base 7 and is not limited especially.

And also, the base 7 is preferable to have a some surface area for dissipating heat generated by the light emission of the LED lamp 2.

Moreover, as the LED lamp 2 may be used a widely commercially available one.

The beam-condensing element 3 comprises a beam-condensing portion 9 having a translucent concave end face 3a which is the same curvature as a translucent convex face 6 of the LED lamp 2 and extending from a peripheral edge 10 of the translucent concave end face 3a along a shape of a parabolic rotating body.

As the beam-condensing element 3 are mentioned transparent materials such as polystyrene, styrene-methylmethacrylate copolymer, (metha)acrylic resin, polymethylpentene, allyl glycol carbonate resin, spiran resin, amorphous polyolefin, polycarbonate, polyamide, polyarylate, polysulfon, polyallylsulfon, polyethersulfon, polyether imide, polyimide, diallyl phthalate, fluoride resin, polyester carbonate, norbornene resin (ARTON), alicyclic acrylic resin (OPTOLET), silicone resin, acrylic rubber, silicone rubber and the like. They are preferable to be used alone or in a combination of two or more.

A main feature of the construction in the beam-condensing element according to the first aspect of the invention and the LED lamp with the beam-condensing element according to the third aspect of the invention lies in rationalizing a shape of the beam-condensing portion 9 of the beam-condensing element 3. More concretely, when viewing at a section including a rotation axis n of the beam-condensing portion 9, an inclination of tangent m drawn to the beam-condensing portion 9 at a position 10 of the peripheral edge of the translucent concave end face 3a with respect to the rotation axis n is set up so that an incidence efficiency of light beams emitted from the LED lamp 2 to the beam-condensing portion 9 is not less than a given value. By adopting this construction can effectively be captured the incident light from the LED lamp 2 in the beam-condensing portion 9 at a state that an area of the end face (strictly, the translucent concave end face 3a) located at the light-incidence side of the beam-condensing element 3 is as small as possible, while the thus captured incident light can be emitted from the beam-condensing element 3 as a high brightness light having a small spot diameter and an excellent directivity.

Next, details running into the accomplishment of the first and third aspects of the invention will be explained together with an action.

In case of the conventional beam-condensing element for LED lamp (see FIG. 7), as a result that the area of the end face located at the light-incidence side of the beam-condensing element becomes wide, the size of the beam-condensing element itself is enlarged and the spot diameter of the emitted light is also increased, and hence the sufficient directivity can not be obtained and the high brightness light can not be emitted as previously mentioned.

In order to make the size of the beam-condensing element itself as small as possible, therefore, the inventors have made studies with respect to the shape of the beam-condensing element capable of emitting the high brightness light having a small spot diameter and an excellent directivity without enlarging the area of the end face located at the light-incidence side of the beam-condensing element.

As a result, it has been found that the light emitted from the LED lamp 2 can be incident into the beam-condensing portion 9 in a high efficiency by rationalizing the shape of the beam-condensing portion 9 in the beam-condensing element 3 particularly located at the light-incidence side thereof, or by rationalizing the inclination of tangent m drawn to the beam-condensing portion 9 at a peripheral edge position 10 of the translucent concave end face 3a of the beam-condensing element 3 with respect to the rotation axis n as shown in FIG. 2.

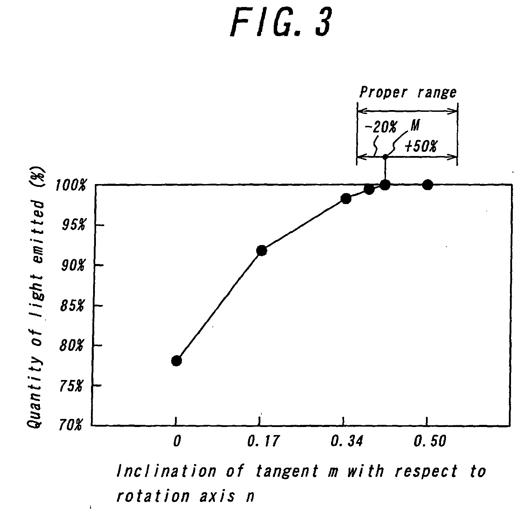

FIG. 3 shows a relationship between the inclination of tangent m with respect to the rotation axis n of the beam-condensing portion 9 as an abscissa and the quantity of the light emitted from the end face 3b located at the light-emitting side of the beam-condensing element 3. Since it can be considered that the quantity of the light emitted is substantially the same as the incidence efficiency of light beams incident into the beam-condensing portion 9 of the beam-condensing element 3, FIG. 3 may be substantially considered to show a relationship between the inclination of tangent m and the incidence efficiency. Moreover, the quantity of the emitted light shown in FIG. 3 is represented by a percentage (%) when its maximum value is 100%.

From the result of FIG. 3, it is understood that the incidence efficiency (the quantity of the emitted light) is largely changed in accordance with the inclination of tangent m.

To this end, the beam-condensing element 3 according to the first aspect of the invention is made an essential requirement that the inclination of tangent m is set up so that the incidence efficiency (the quantity of the emitted light) when the light beam emitted from the LED lamp 2 is incident into the beam-condensing portion 9 becomes not less than a given value, concretely not less than 60%, preferably not less than 70%, more preferably not less than 85%.

And also, when the incidence efficiency in the beam-condensing portion 9 is not less than 85%, the inclination of tangent m is preferable to be not less than 0.15. When the inclination of tangent m exceeds 1.00, the diameter of the beam-condensing portion becomes larger, and the area of the end face 3b located at the light-emitting side of the beam-condensing element 3 is large accompanied therewith, so that the size of the beam-condensing element 3 is enlarged and the spot diameter also becomes large. Therefore, the upper limit of the inclination of tangent m is preferable to be 1.00. Moreover, the range of the inclination of tangent m is preferably 0.2-0.8, more preferably 0.3-0.6.

Furthermore, the length L of the beam-condensing element 3 is preferable to be not less than 10 mm as measured on the rotation axis n in order to obtain the sufficient quantity of the light emitted. Moreover, when the beam-condensing element becomes longer to increase the size, it can not be applied to the use application requiring the space-saving. In such a case, the length L of the beam-condensing element 3 is preferable to be not more than 100 mm, preferably not more than 80 mm, more preferably not more than 50 mm.

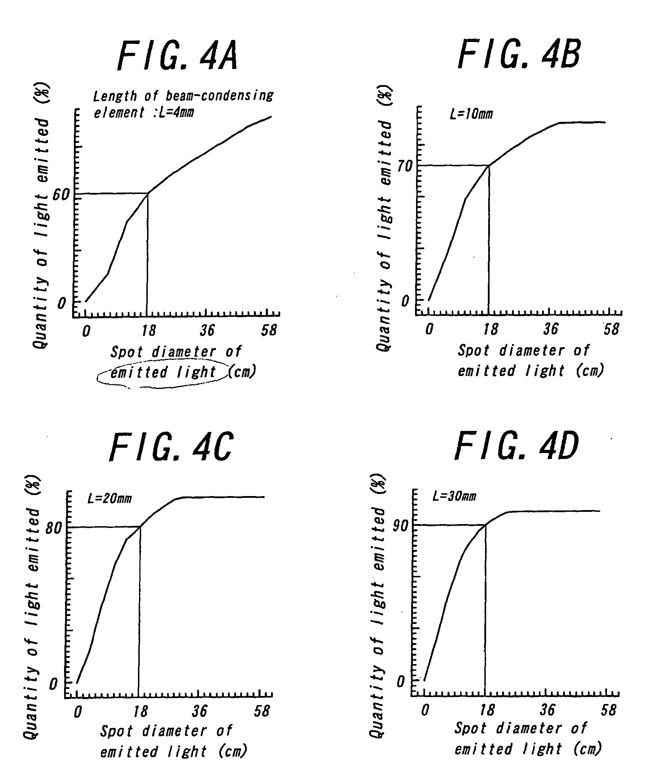

FIGS. 4A-4D show a relationship between the spot diameter of the emitted light and the quantity of the emitted light (%) as measured at a position of 1 m separated from the end face 3b located at the light-emitting side of the beam-condensing element 3 when the length L of the beam-condensing element 3 is changed into 4 mm, 10 mm, 20 mm and 30 mm, respectively. In case of comparing them in the spot diameter of 18 cm, the longer the length L of the beam-condensing element 3, the larger the quantity of the emitted light. This means that as the length of the beam-condensing element becomes longer, the ratio of the incident light reflected at a side face of the beam-condensing element 3, that is, the ratio of parallel beams becomes higher and hence the high-brightness light having an excellent directivity is obtained.

And also, the area of the end face 3b located at the light-emitting side of the beam-condensing element 3 is preferable to be not more than 1000 mm², preferably not more than 625 mm², more preferably not more than 225 mm² in view of the space-saving

Furthermore, the beam-condensing element 3 is preferable to be integrally united with a substantially cylindrical portion at the light-emitting side of the beam-condensing portion 9 in view of making smaller the area of the end face 3b located at the light-emitting side of the beam-condensing element 3.

An embodiment of the method of forming the beam-condensing element according to the second aspect of the invention will be explained below.

Firstly, there are formed a plurality of beam-condensing elements 3 provided with beam-condensing portions 9 having different inclinations of tangent drawn to the beam-condensing portion 9 at a peripheral edge position of a translucent concave end face 6 of the beam-condensing element 3 with respect to a rotation axis n when viewing at a section including the rotation axis n of the beam-condensing portion 9.

Next, each of the beam-condensing elements 3 is put on a LED lamp 2 and then a light is emitted from the LED lamp 2. At this time, an incidence efficiency (quantity of the light emitted) when the light is incident into each of the beam-condensing elements 3 is measured to plot the incidence efficiency (quantity of the emitted light) with respect to the inclination of tangent m as shown in FIG. 4A.

Then, the inclination of tangent that the measured incidence efficiency (quantity of the emitted light) indicates not less than a given value is selected, and a beam-condensing element provided with a beam-condensing portion is formed so as to satisfy the selected inclination of tangent m.

Moreover, as a method of selecting the inclination of tangent m, it is more preferable that a minimum value M (FIG. 3) of the inclination of tangent m in correspondence with a maximum value of the incidence efficiency among values of the incidence efficiency measured on the plural beam-condensing elements 3 provided with beam-condensing portions 9 having different inclinations of tangent m with respect to the rotation axis n is selected, and the inclination of tangent m is set to a range of -20% to +50% of the selected minimum value M.

When the LED lamp with the beam-condensing element 3 according to the third aspect of the invention is constituted by forming the above rationalized beam-condensing element 3 according to the first aspect of the invention and putting this beam-condensing element 3 on the LED lamp 2, it is possible to emit a high-brightness light having a small spot diameter and an excellent directivity and is also possible to use in lamp fittings for vehicles such as a brake lamp or the like.

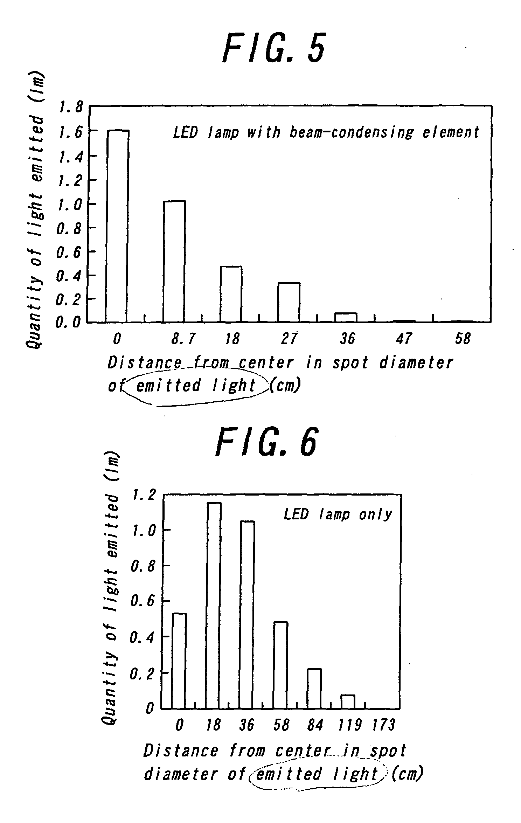

In FIG. 5 are plotted quantities of the emitted light with respect to a distance from a center position in the spot diameter of the incident light when using the LED lamp with the beam-condensing element according to the third aspect of the invention (invention product). For the comparison, FIG. 6 shows the data plotted when using only a LED lamp without the beam-condensing element (conventional product).

As seen from the results of FIGS. 5 and 6, the emitted light in the invention product is condensed in an area of a small spot diameter as compared with the conventional product, and the brightness in the invention product is highest at the center position of the spot diameter and is decreased in accordance with the separating from the center of the spot diameter, while the sufficient brightness in the conventional product can not be obtained at the center of the spot diameter.

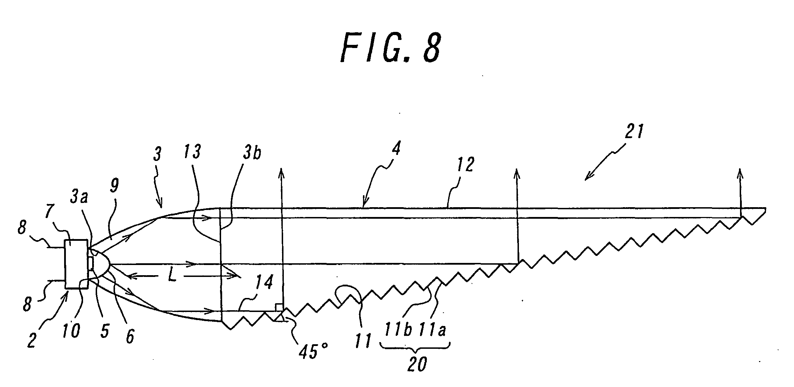

Also, FIG. 8 shows a side view of an embodiment of the representative linear light-emitting apparatus according to the fourth aspect of the invention.

A main part of the linear light-emitting apparatus 21 shown in FIG. 8 is constituted by integrally uniting a LED lamp 2, a beam-condensing element 3 and an illuminant 4.

The LED lamp 2 and the beam-condensing element 3 are the same as the above-mentioned beam-condensing element according to the first aspect of the invention.

The illuminant 4 is joined to an end face 3b located at a light-emitting side of the beam-condensing element 3 or integrally molded to the beam-condensing element 3 and provided with a reflection face 11 reflecting the light emitted from the end face 3b of the beam-condensing element 3 at a given angle, concretely 60-150°, preferably 70-130°, more preferably 85-110° and a luminous face 12 located at an opposite side of the reflection face 11, in which the light beams reflected from the reflection face 11 are linearly emitted from the luminous face 12.

Moreover, when the illuminant is joined to the end face 3b located at the light-emitting side of the beam-condensing element 3, it is necessary to constitute so as not to generate the refraction at the joined interface. In this case, it is preferable to use a colorless and transparent adhesive such as acrylic, epoxy or urethane based photo-setting or thermosetting resin.

A main feature of the construction in the fourth aspect of the invention lies in rationalizing the shape of the beam-condensing portion 9 of the beam-condensing element 3 likewise the above-mentioned first and third aspects of the invention. More concretely, when viewing at a section including the rotation axis n of the beam-condensing portion 9, the inclination of tangent m drawn to the beam-condensing portion 9 at the peripheral edge position 10 of the translucent concave end face 3a with respect to the rotation axis n is set up so that the incidence efficiency when light beams emitted from the LED lamp 2 are incident into the beam-condensing portion 9 is not less than a given value. By adopting this construction can be effectively captured the incident light from the LED lamp 2 in the beam-condensing portion 9 at a state of making the area of the end face (strictly, the translucent concave end face 3a) located at the light-incidence side of the beam-condensing element 3 as small as possible, and the diameter in the end face 3b located at the light-incidence side of the beam-condensing element 3 can be made small accompanied therewith, and hence the high-brightness light having an excellent directivity can be linearly emitted through the illuminant 4.

The construction of the illuminant 4 is not particularly limited unless the light beams incident from the beam-condensing element 3 are reflected at a given angle to emit linear light beams. To take an example of such a construction, as shown in FIG. 8, the illuminant can be constructed that it is substantially wedge-shape and a side face thereof has a shape of substantially a right-angled triangle comprising the reflection face 11 as a hypotenuse, the luminous face 12 located opposite to the reflection face 11 as a base and a joint face 13 to the beam-condensing element as the remaining side, and that the reflection face 11 is zigzag formed by a connection of convex portions 20 each comprised of two line segments 11a, 11b extending in the different directions with respect to each other and an extending direction of either of the two line segments, or the line segment 11b in FIG. 8 is made an angle of 45° with respect to a forward direction of the light incident into the illuminant 4.

And also, it is preferable that in order to effectively capture the light emitted from the beam-condensing element 3 in the illuminant 4, the joint face 13 of the illuminant 4 has an area capable of joining to a whole area of the end face 3b located at the light-emitting side of the beam-condensing element 3. Concretely, this means that when the end face 3b located at the light-emitting side of the beam-condensing element 3 has a round shape and the joint face 13 of the illuminant 4 has a quadrilateral shape as shown in FIG. 8, the area of the latter is made larger than that of the former so as to place the round shape of the former into the quadrilateral shape of the latter, and that when both the shapes are the same (when both the shapes have a round shape, a quadrilateral shape or the like), the area of the latter is made equal to or larger than that of the former.

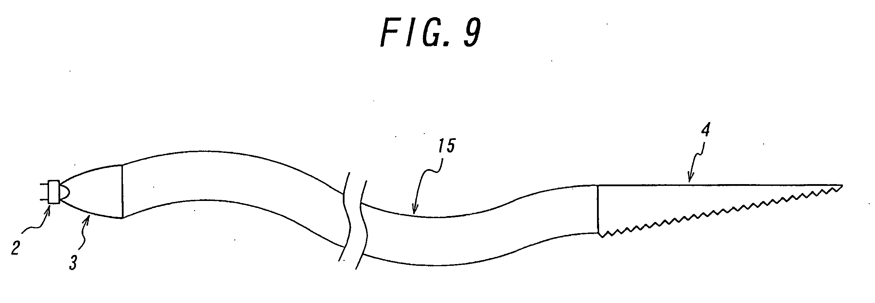

If it is required to arrange the illuminant 4 apart from the position of the light source (LED lamp 2), for example, when it is required to arrange the light source so as to be far from a moist place, it is preferable that the illuminant 4 is integrally connected to the beam-condensing element 3 through an optical transmission tube 15 set to a desired length as shown in FIG. 9.

Moreover, as the optical transmission tube 15 may be used a conventionally known optical transmission tube constituted with a tubular clad and a core made of a material having a refractive index higher than that of a material constituting the tubular clad.

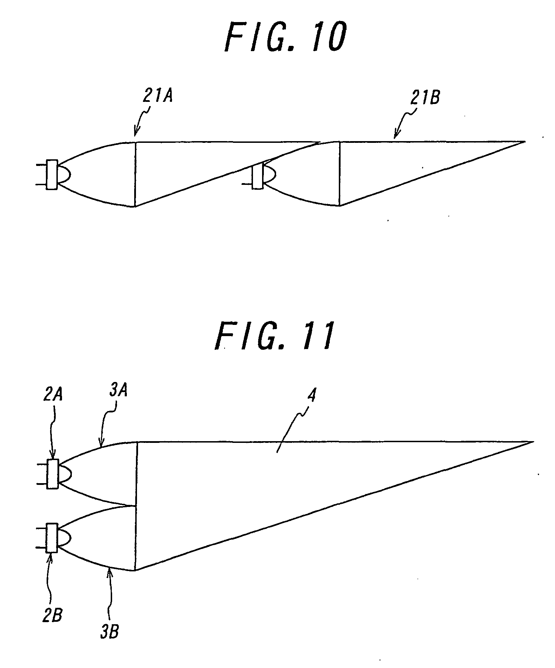

And also, the length of the linear illuminant 4 is naturally critical in case of providing a sufficient brightness by using a single LED lamp. If it is required to form the length of the illuminant 4 beyond its limit, as shown in FIG. 10, it is preferable to use a plurality of linear light-emitting apparatuses 21A, 21B so as to arrange them side by side.

Furthermore, when plural LED lamps 2A, 2B and plural condensing elements 3A, 3B are connected to the single illuminant 4 as shown in FIG. 11, the mixing effect can be expected, and this construction is advantageous to erase color shade.

When the above rationalized beam-condensing element 3 is used and this beam-condensing element 3 is put on the LED lamp 2 and the illuminant 4 is integrally connected to the end face 3b located at the light-emitting side of the beam-condensing element 3, even if the LED lamp is used as a light source, it is possible to linearly emit the high-brightness light having an excellent directivity and also it is possible to use in the lamp fittings for vehicles such as a high mount brake lamp and the like.

Furthermore, the area of the end face 3b located at the light-emitting side of the beam-condensing element 3 can be made small by integrally forming a substantially cylindrical portion at the light-emitting side of the beam-condensing portion 9 in the beam-condensing element 3, which is more preferable in view of thinning the line width of the illuminant 4 to enhance the brightness.

Thus, the linear light-emitting apparatus of the fourth aspect of the invention can emit the linear light beams having a high brightness. As to the above linear light-emitting apparatus, the inventors have made further studies about the brightness of the linear light beam in the longitudinal direction and found that the brightness of such a linear light beam tends to be somewhat inferior at both end portions, particularly the end portions located at the light-incidence side of the illuminant as compared with at the central portion thereof.

To this end, a main feature of the construction in the fifth aspect of the invention lies in rationalizing a shape of the beam-condensing portion 9 of the beam-condensing element 3 and a shape of the illuminant 4, particularly the reflection face 11 of the illuminant 4. More concretely, when viewing at a section including a rotation axis n of the beam-condensing portion 9, an inclination of tangent m drawn to the beam-condensing portion 3 at a peripheral edge position 10 of the translucent concave end face 3a with respect to the rotation axis n is set up so that an incidence efficiency when a light emitted from the LED lamp 2 is incident into the beam-condensing portion 9 becomes not less than a given value and the reflection face 11 of the illuminant 4 is provided with a brightness uniformalizing means. By adopting these constructions can be effectively captured the incident light from the LED lamp 2 in the beam-condensing portion 9 at a state of making the area of the end face located at the light-incidence side of the beam-condensing element 3 (strictly, the translucent concave end face 3a) as small as possible, and the diameter of the end face 3b located at the light-emitting side of the beam-condensing element can be made small accompanied therewith, whereby the high-brightness light beams having an excellent directivity can be linearly emitted through the illuminant 4. In addition, by arranging the above brightness uniformalizing means on the reflection face 11 of the illuminant 4 can be further uniformalized the brightness of the linear light beam in the longitudinal direction as compared with the brightness of the linear light beam emitted from the illuminant of the linear light-emitting apparatus according to the fourth aspect of the invention.

It is preferable that the brightness uniformalizing means is constituted so that a reflectance of light on the reflection face 11 of the illuminant 4 is made larger at a part 19a of the reflection face at least located at an end portion 16 of a light-incidence side of the illuminant 4 than at other parts 19b, 19c of the reflection face 11 located at other portions 17, 18 of the illuminant 4. More concretely, it is preferable that an average inclination angle α of the reflection face 11 with respect to an extension of the rotation axis is made larger at the part 19a of the reflection face at least located at the end portion 16 of the light-incidence side of the illuminant 4 than at other parts 19b, 19c of the reflection face and/or an average arranging number of the convex portions 20 constituting the reflection face 11 is made larger at the part 19a of the reflection face at least located at the end portion 16 of the light-incidence side of the illuminant 4 than at other parts 19b, 19c of the reflection face.

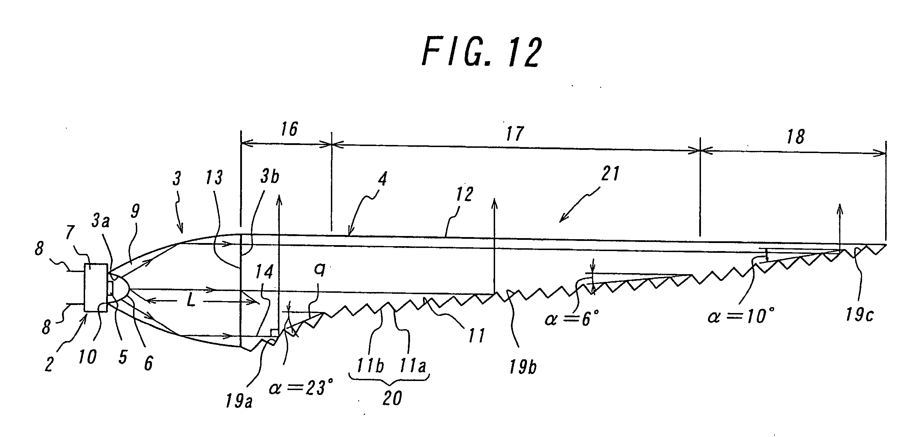

Moreover, the term "average inclination angle α" used herein means an angle with respect to the extension of the rotation axis n of the reflection face when the reflection face 11 is a flat surface, or an angle of a line q formed by connecting apexes of convex portions 20 to each other with respect to the extension of the rotation axis n when the reflection face is not a flat surface, for example, when it is formed by the connection of the convex portions 20 as shown in FIG. 12. And also, the term "average arranging number of the convex portions 20" means an arranging number of convex portions 20 per a unit length of the illuminant 4.

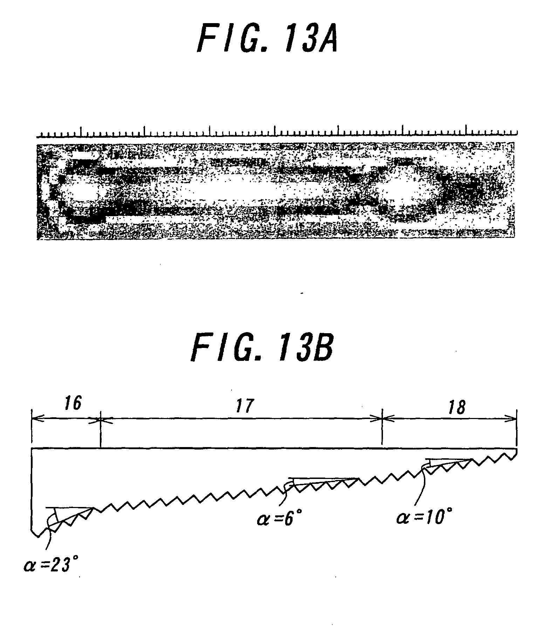

FIG. 13B is a side view of an illuminant (invention example) of the light-emitting apparatus according to the fifth aspect of the invention and is a case that the reflection face 11 is provided with the brightness uniformalizing means so that the average inclination angle α is 23° at the reflection face part 19a located at the light-incidence side of the illuminant 4 and 6° at the other reflection face parts 19b, 19c, particularly, the reflection face part 19b located at a central portion and the former is made larger than the latter. Moreover, in this figure, in order to improve both the brightness in the end part 16 located at the light-incidence side of the illuminant 4 and the brightness in the end part 18 located at the terminated side thereof, the average inclination angle of the reflection face part 19c located at the end part 18 of the terminated side of the illuminant 4 is 10° and is set to be somewhat larger than that of the reflection face part 19b located at the central part 17 of the illuminant 4. However, the average inclination angle in the end part 18 located at the terminated side of the illuminant 4 can be properly changed if it is required to uniformalize the brightness.

Also, FIG. 13A is a view showing the brightness distribution of linear light beams measured when using the illuminant 4 shown in FIG. 13B.

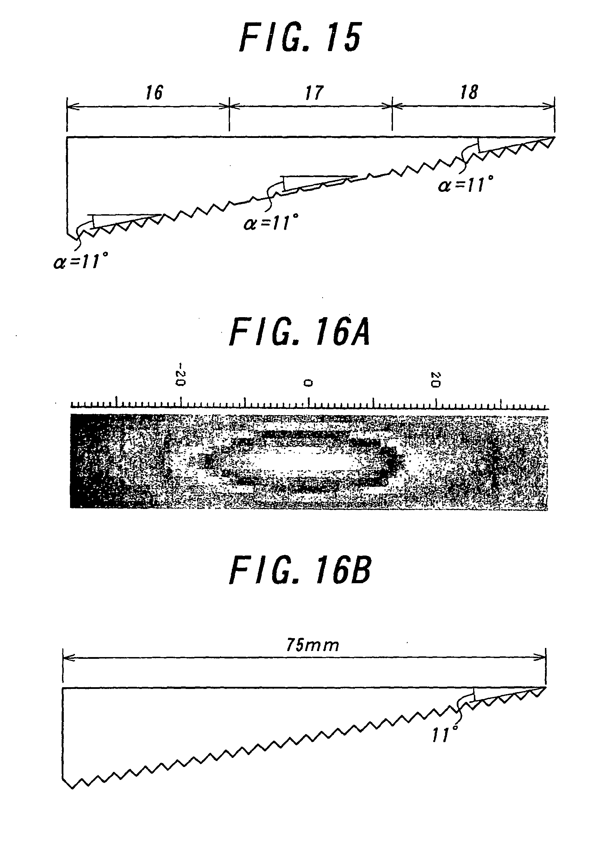

For the comparison, FIGS. 16A and 16B are a view of the brightness distribution of linear light beams measured and a side view of an illuminant, respectively, when the reflection face 11 of the illuminant 4 is not provided with the brightness uniformalizing means for uniformalizing the brightness of linear light beams in the longitudinal direction, or when the average inclination angle of the whole of the reflection face 11 is set constant (11°) (Comparative Example).

As seen from these figures, in case of the comparative example, the brightness of the linear light beam is high at the central part 17 and low at both the end parts 16, 18, while in case of the invention example, the difference in the brightness of the linear light beam between the central part 17 and the both end parts 16, 18 becomes small as compared with the comparative example and the brightness of the linear light beam becomes uniform in the longitudinal direction.

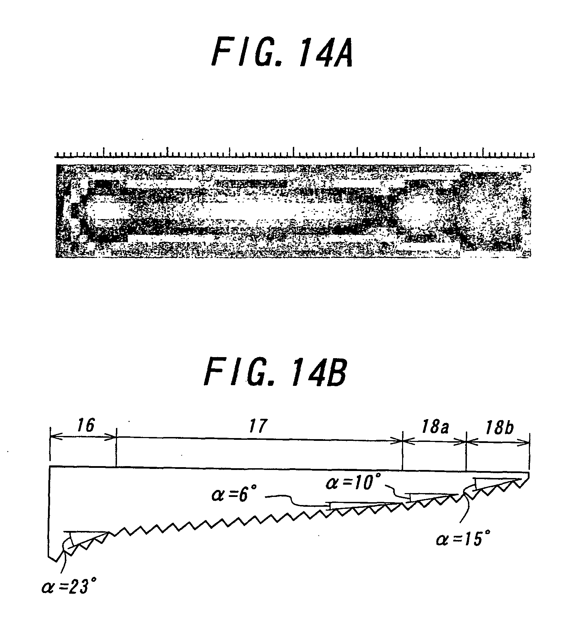

And also, FIGS. 14A and 14B are another example of the illuminant used in the linear light-emitting apparatus according to the fifth aspect of the invention, in which the end part 18 located at the terminated side of the illuminant 4 shown in FIG. 13B is further divided into two parts 18a, 18b and the average inclination angle at the part 18b located at more terminated side of the end part 18 is made lager than at the other part 18a thereof. In case of using the illustrated illuminant, it is understood that the linear light beams are made more uniform.

Furthermore, FIG. 15 is the other example of the illuminant used in the linear light-emitting apparatus according to the fifth aspect of the invention, in which the average arranging number of the convex portions constituting the reflection face is made larger at both the end parts 16, 18 of the illuminant than at the central part 17 thereof though the average inclination angle α of the reflection face is constant (11° in this figure). Even when using the illustrated illuminant, it has been confirmed that the uniformalization of linear light beams can be attained likewise the case of FIG 13(a). Moreover, FIG. 1 shows the case that the average arranging number of the convex portions is made larger at both the end parts 16, 18 of the illuminant than at the central part 17 by making the size of the convex portion constituting the reflection face at both the end parts 16, 18 of the illuminant larger than at the center part 17, but it is not limited to this case.

As the brightness uniformalizing means, FIGS. 13B and 14B show the adoption of the method wherein the average inclination angle is properly set every the part 19a-19c of the reflection face 11 and FIG. 15 shows the adoption of the method wherein the average arranging number of the convex portions 20 is properly set every the part 19a-19c of the reflection face 11, but these methods may be combined.

Furthermore, if it is intended to obtain the mixing effect by adopting such a constitution that plural LED lamps 2A, 2B and plural beam-condensing elements 3A, 3B are connected to a single illuminant 4 as shown in FIG. 11, the number of low-brightness parts generated in the illuminant 4 increases in proportion to the number of the LED lamps, so that it is preferable to rationalize the reflection face in correspondence to the low-brightness parts of the illuminant.

Although the above is described with respect to only a preferred embodiment of the invention, various modifications may be taken within a scope of the invention

### INDUSTRIAL APPLICABILITY

In the LED lamp with the beam-condensing element according to the third aspect of the invention and the linear light-emitting apparatus according to the fourth and fifth aspects of the invention, the incident light emitted from the LED lamp can be effectively captured in the beam-condensing portion by rationalizing the shape of the beam-condensing element, particularly the shape of the beam-condensing portion thereof without enlarging the area of the end face located at the light-incidence side of the beam-condensing element, so that the high-brightness spot light having an excellent directivity can be emitted in the third aspect of the invention, and the high-brightness linear light having an excellent directivity can be emitted in the fourth aspect of the invention, and the high-brightness linear light having an excellent directivity and being uniform in the longitudinal direction can be emitted in the fifth aspect of the invention, respectively.

Therefore, the LED lamp with the beam-condensing element according to the third aspect of the invention and the linear light-emitting apparatus according to the fourth and fifth aspects of the invention have advantages that the consumed power is low and the service life is long and the like, so that they are naturally applicable to the lamp fittings for vehicles such as a high mount brake lamp and the like, but also can be widely used in all fields.

## Claims

1. A beam-condensing element comprising a beam-condensing portion having a translucent concave end face, which is the same curvature as a translucent convex face of a LED lamp comprising a LED chip and a substantially hemispherical translucent convex face enveloping the LED chip, and extending from a peripheral edge of the translucent concave end face in a shape of a parabolic rotating body, in which when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value.

2. A beam-condensing element according to claim 1, wherein the inclination of tangent with respect to the rotation axis is a range of 0.15-1.00.

3. A beam-condensing element according to claim 1 or 2, wherein a length of the beam-condensing element is not less than 10 mm as measured on the rotation axis.

4. A beam-condensing element according to claim 1, 2 or 3, wherein an area of an end face located at a light-emitting side of the beam-condensing element is not more than 1000 mm².

5. A beam-condensing element according to any one of claims 1 to 4, wherein the beam-condensing element is provided with a substantially cylindrical portion integrally united with the beam-condensing portion at the light-emitting side thereof.

6. A method of forming a beam-condensing element comprising a beam-condensing portion having a translucent concave end face, which is the same curvature as a translucent convex face of a LED lamp comprising a LED chip and a substantially hemispherical translucent convex face enveloping the LED chip, and extending from a peripheral edge of the translucent concave end face in a shape of a parabolic rotating body, which comprises forming a plurality of beam-condensing elements provided with beam-condensing portions having different inclinations of tangent drawn to the beam-condensing portion at a peripheral edge position of the translucent concave end face with respect to a rotation axis when viewing at a cross section including the rotation axis of the beam-condensing portion, putting each of these beam-condensing elements on a LED lamp, emitting a light from the LED lamp to measure an incidence efficiency when the light is incident into each of the beam-condensing elements, selecting an inclination of tangent that the measured incidence efficiency indicates not less than a given value from the above different inclinations, and then forming a beam-condensing element provided with a beam-condensing portion so as to satisfy the selected inclination of tangent.

7. A method of forming a beam-condensing element according to claim 6, wherein the beam-condensing element provided with the beam-condensing portion is formed by selecting a minimum value of the inclination of tangent in correspondence with a maximum value of the incidence efficiency among values of the incidence efficiency measured on the plural beam-condensing elements provided with beam-condensing portions having different inclinations of tangent with respect to the rotation axis and setting the inclination of tangent to a range of -20% to +50% of the selected minimum value.

8. A LED lamp with a beam-condensing element, which comprises a LED lamp comprising a LED chip and a substantially hemispherical translucent convex face enveloping the LED chip, and a beam-condensing element comprising a beam-condensing portion having a translucent concave end face, which is the same curvature as the translucent convex face of the LED lamp for putting on the translucent convex face thereof, and extending from a peripheral edge of the translucent concave end face in a shape of a parabolic rotating body, in which the LED lamp and the beam-condensing element are integrally united together, and when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value.

9. A linear light-emitting apparatus using a LED lamp as a light source, which comprises a LED lamp comprising a LED chip and a substantially hemispherical translucent convex face enveloping the LED chip, and a beam-condensing element comprising a beam-condensing portion having a translucent concave end face, which is the same curvature as the translucent convex face of the LED lamp for putting on the translucent convex face thereof, and extending from a peripheral edge of the translucent concave end face in a shape of a parabolic rotating body, and an illuminant joined to an end face located at a light-emitting side of the beam-condensing element or integrally molded to the beam-condensing element and provided with a reflection face reflecting the light emitted from the end face of the beam-condensing element at a given angle to emit linear light beams, in which the LED lamp, the beam-condensing element and the illuminant are integrally united together.

10. A linear light-emitting apparatus using a LED lamp as a light source, which comprises a LED lamp comprising a LED chip and a substantially hemispherical translucent convex face enveloping the LED chip, and a beam-condensing element comprising a beam-condensing portion having a translucent concave end face, which is the same curvature as the translucent convex face of the LED lamp for putting on the translucent convex face thereof, and extending from a peripheral edge of the translucent concave end face in a shape of a parabolic rotating body, and an illuminant joined to an end face located at a light-emitting side of the beam-condensing element or integrally molded to the beam-condensing element and provided with a reflection face reflecting the light emitted from the end face of the beam-condensing element and a luminous face linearly emitting light beans reflected from the reflection face, in which the LED lamp, the beam-condensing element and the illuminant are integrally united together, and a brightness uniformalizing means arranged on the reflection face of the illuminant.

11. A linear light-emitting apparatus according to claim 9 or 10, wherein when viewing at a cross section including a rotation axis of the beam-condensing portion, an inclination of tangent drawn to the beam-condensing portion at a peripheral edge position of the translucent concave end face with respect to the rotation axis is set up so that an incidence efficiency of light beams emitted from the LED lamp to the beam-condensing portion is not less than a given value.

12. A linear light-emitting apparatus according to claim 11, wherein the inclination of tangent with respect to the rotation axis is a range of 0.15-1.00.

13. A linear light-emitting apparatus according to any one of claims 9 to 12, wherein a length of the beam-condensing element is not less than 10 mm as measured on the rotation axis.

14. A linear light-emitting apparatus according to any one of claims 9 to 13, wherein an area of an end face located at a light-emitting side of the beam-condensing element is not more than 1000 mm².

15. A linear light-emitting apparatus according to any one of claims 9 to 14, wherein the beam-condensing element is provided with a substantially cylindrical portion integrally united with the beam-condensing portion at the light-emitting side thereof.

16. A linear light-emitting apparatus according to any one of claims 9 to 15, wherein the illuminant is substantially wedge-shape and a side face thereof has a shape of substantially a right-angled triangle comprising the reflection face as a hypotenuse, the luminous face located opposite to the reflection face as a base and a joint face to the beam-condensing element as the remaining side, and the reflection face is zigzag formed by a connection of convex portions each comprised of two line segments extending in the different directions with respect to each other and an extending direction of either of the two line segments is made a given angle with respect to a forward direction of the light beam incident into the illuminant.

17. A linear light-emitting apparatus according to claim 16, wherein the joint face of the illuminant has an area capable of joining to a whole area of the end face located at the light-emitting side of the beam-condensing element.

18. A linear light-emitting apparatus according to any one of claims 9 to 17, wherein the illuminant is integrally connected to the beam-condensing element through an optical transmission tube.

19. A linear light-emitting apparatus according to any one of claims 10 to 18, wherein the brightness uniformalizing means is constituted so that a reflectance of light on the reflection face of the illuminant is made larger at a part of the reflection face at least located at an end portion of the light-incidence side of the illuminant than at the other part of the reflection face located at the other portion of the illuminant.

20. A linear light-emitting apparatus according to any one of claims 10 to 18, wherein the brightness uniformalizing means is constituted so that an average inclination angle of the reflection face with respect to an extension of the rotation axis is made larger at a part of the reflection face at least located at the end portion of the light-incidence side of the illuminant than at other part of the reflection face.

21. A linear light-emitting apparatus according to claim 16, 17 or 18, wherein the brightness uniformalizing means is constituted so that an average arranging number of the convex portions constituting the reflection face is made larger at a part of the reflection face at least located at the end portion of the light-incidence side of the illuminant than at other part of the reflection face.
